(19) **Europäisches Patentamt**

**European Patent Office**

**Office européen des brevets**

(11) **EP 0 692 870 B1**

(12) **EUROPÄISCHE PATENTSCHRIFT**

(45) Veröffentlichungstag und Bekanntmachung des Hinweises auf die Patenterteilung:
**02.11.2000 Patentblatt 2000/44**

(51) Int. Cl.[7]: **H03H 11/40**

(21) Anmeldenummer: **95201773.9**

(22) Anmeldetag: **29.06.1995**

(54) **Schaltungsanordnung zur Kapazitätsverstärkung**

Capacitance multiplier circuit

Circuit multiplicateur de capacitance

(84) Benannte Vertragsstaaten:
**DE FR GB IT**

(30) Priorität: **12.07.1994 DE 4424527**

(43) Veröffentlichungstag der Anmeldung:
**17.01.1996 Patentblatt 1996/03**

(73) Patentinhaber:
• **Philips Corporate Intellectual Property GmbH**
**52064 Aachen (DE)**
Benannte Vertragsstaaten:
**DE**
• **Koninklijke Philips Electronics N.V.**
**5621 BA Eindhoven (NL)**
Benannte Vertragsstaaten:
**FR GB IT**

(72) Erfinder:
**Soltau, Andreas,**
**c/o Philips**
**D-20097 Hamburg (DE)**

(74) Vertreter:
**von Laue, Hanns-Ulrich, Dipl.-Ing.**
**Philips Corporate Intellectual Property GmbH,**
**Habsburgerallee 11**
**52064 Aachen (DE)**

(56) Entgegenhaltungen:
**EP-A- 0 109 081      EP-A- 0 602 723**
**US-A- 4 682 059**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Schaltungsanordnung zur Verstärkung der Wirkung einer Kapazität.

In integrierten Schaltkreisen stellt sich das Problem, daß Kapazitäten mit großen Werten nicht realisierbar sind, da diese eine zu große Chipfläche benötigten. Es muß also eine entsprechend große Kapazität entweder extern vorgesehen werden oder eine entsprechene Kapazität elektronisch in dem Schaltkreis auf dem IC simuliert werden. Dazu ist aus dem Aufsatz "Design and Implementation of a CMOS VCXO for FM Stereo Decoders", aus IEEE Journal of Solid-State Circuits, Vol. 23, No. 3, June 1988, Seiten 784 bis 793 eine Schaltungsanordnung bekannt, in welcher hohe Kapazitäts-Werte elektronisch simuliert werden. Dazu ist eine Schaltung mit Operationsverstärkern vorgesehen.

Aus der EP-A-0 620 723 ist eine Schaltungsanordnung zur Verstärkung der Wirkung einer Admittanz bekannt, welche mittels einer Stromspiegelschaltung arbeitet und bei welcher das Maß der Verstärkung der Wirkung der Admittanz vom Flächenverhältnis des Eingangstransistors der Stromspiegelschaltung und des Ausgangstransistors der Stromspiegelschaltung abhängig ist.

Es ist Aufgabe der Erfindung, eine Schaltungsanordnung zur elektronischen Verstärkung der Wirkung einer Kapazität anzugeben, welche einen möglichst einfachen Aufbau bei weiter verbesserten Eigenschaften aufweist.

Die oben angegebene Aufgabe ist dadurch gelöst, daß eine Wilson-StromspiegelSchaltung vorgesehen ist, welche einen ersten Transistor aufweist, dessen Kollektor den Eingang der Stromspiegelschaltung bildet, dessen Emitter auf Bezugspotential geführt ist und dessen Basis mit der Basis eines zweiten in der Stromspiegelschaltung vorgesehenen zweiten Transistors verbunden ist, dessen Emitter mit Bezugspotential und dessen Kollektor mit dessen Basis und mit dem Emitter eines dritten in der Stromspiegel-Schaltung vorgesehenen Transistors verbunden ist, dessen Basis mit dem Eingang der Stromspiegel-Schaltung verbunden ist und dessen Kollektor den Ausgang der Stromspiegel-Schaltung bildet, daß der Eingang der Schaltungsanordnung mit dem Ausgang einer Stromverstärker-Schaltung und über die Kapazität mit dem Verbindungspunkt zwischen dem zweiten und dem dritten Transistor der Wilson-Stromspiegelschaltung verbunden ist, daß der Ausgang der Wilson-Stromspiegel-Schaltung mit dem Eingang der Stromverstärker-Schaltung verbunden ist und daß auf den Eingang und auf den Ausgang der Wilson-Stromspiegel-Schaltung zusätzlich konstante Ströme jeweils gleicher Größe geführt sind.

Es ist hier eine Stromspiegel-Schaltung zur Verstärkung der Wirkung des Stromes durch die Kapazität vorgesehen. Es wird jedoch ein Wilson-Stromspiegel eingesetzt, der in an sich bekannter Weise mit drei Transistoren und einer Rückkopplung der Verstärkung verschaltet ist.

Das Eingangssignal der gesamten Schaltungsanordnung gelangt einerseits über die Kapazität, deren Wirkung elektronisch zu verstärken ist, auf den Verbindungspunkt zwischen den zweiten und dem dritten Transistor des Wilson-Stromspiegels. Außerdem ist der Eingang der gesamten Schaltungsanordnung mit dem Ausgang der Stromverstärker-Schaltung verbunden, deren Eingang auf den Ausgang des Wilson-Stromspiegels geschaltet ist.

Eingangsseitig ist dem Wilson-Stromspiegel ein konstanter Strom einer bestimmten Größe zugeführt. Dem Ausgang des Wilson-Stromspiegels wird ebenfalls ein konstanter Strom zugeführt, der im Verhältnis zu dem ihm eingangsseitig geführten Strom im gleichen Verhältnis steht, wie die Stromverstärkung der Stromspiegel-Schaltung. Verstärkt also die Stromspiegel-Schaltung den eingangsseitig zugeführten Strom um den Faktor 2, so ist der dem Ausgang des Wilson-Stromspiegels zugeführte Strom ebenfalls um den Faktor 2 höher als der eingangsseitig zugeführte Strom.

Damit ist erreicht, daß der eingangsseitig zugeführte Strom am Ausgang des Wilson-Stromspiegels wieder kompensiert wird. Da jedoch außerdem dem Verbindungspunkt zwischen dem zweiten und dem dritten Transistor der durch die Kapazität fließende Strom zugeführt wird, tritt dieser Strom ebenfalls am Ausgang des Wilson-Stromspiegels auf. Dort wird dieser Strom wieder entnommen und der Stromverstärker-Schaltung zugeführt. Das Ausgangssignal der Stromverstärker-Schaltung und der Strom durch die Kapazität bilden gemeinsam den Eingangs- bzw. Ausgangsstrom der gesamten Schaltungsanordnung.

Die Schaltungsanordnung mit dem Wilson-Stromspiegel ist recht einfach aufgebaut und weist den Vorteil auf, daß der Verbindungspunkt zwischen dem zweiten und dem dritten Transistor des Wilson-Stromspiegels, auf den der Strom durch die Kapazität geführt wird, relativ niederohmig gegen Masse ist. Dies ist von Bedeutung, da es sich bei dem Strom möglichst um einen reinen kapazitiven Strom handeln soll und somit ohmsche Anteile in der Last unerwünscht sind. Eine derartige Schaltungsanordnung eignet sich insbesondere für integrierte Schaltungen, in denen große Kapaziäten aufgrund von deren Flächenbedarf nicht zu realisieren sind.

Ist, wie gemäß einer Ausgestaltung vorgesehen, die Steilheit der Stromverstärkungs-Kennlinie des Stromverstärkers einstellbar, so ist damit das Maß der elektronischen Verstärkung der Wirkung der Kapazität einstellbar. Man hat also im Ergebnis eine elektronisch erzeugte Kapazität, deren Größe einstellbar ist. Eine derartige Schaltung ist vielfältig einsetzbar, insbesondere, wie gemäß einer weiteren Ausgestaltung vorgesehen ist, für einen spannungsgesteuerten Oszillator.

Gemäß einer weiteren Ausgestaltung ist vorgesehen, daß der Stromverstärker eine solche Stromverstärkung aufweist, daß der in die Schaltungsanordnung hineinfließende Strom größer als der durch die Kapazität fließende Strom ist.

Aufgrund der Konzeption der Schaltungsanordnung bildet der Eingangsstrom der gesamten Schaltungsanordnung die Summe aus dem Strom durch die Kapazität und dem Ausgangsstrom des Stromverstärkers. Ist die Kennlinie der Stromverstärkung dieses Stromverstärkers so ausgelegt, daß der Strom durch die Kapazität und der Ausgangsstrom des Stromverstärkers sich gleichsinnig unilagern, so tritt am Eingang der gesamten Schaltungsanordnung die Summe dieser beiden Ströme auf, also ein größerer Strom als der Strom durch die Kapazität. Die Phasenlage beider Ströme entspricht der des Stromes durch die Kapazität. Es liegt hier also eine echte Verstärkung vor, bei der der Eingangsstrom der Schaltungsanordnung in einem wählbaren Umfange größer ist als der Strom durch die Kapazität.

Es besteht jedoch auch die Möglichkeit, wie nach einer weiteren Ausgestaltung der Erfindung vorgesehen ist, daß der Stromverstärker eine solche Stromverstärkung aufweist, so daß der in die Schaltungsanordnung hineinfließende Strom kleiner als der durch die Kapazität fließende Strom ist und gleiche oder um 180 Grad verschobene Phasenlage aufweist. Hierbei ist die Kennlinie des Stromverstärkers bzw. das Vorzeichen der Verstärkung so ausgelegt, daß sich der Strom durch die Kapazität und der Ausgangsstrom der Stromverstärker-Schaltung subtrahieren, also umgekehrtes Vorzeichen haben, und sich so zu dem Eingangssignal der gesamten Schaltungsanordnung überlagern. Damit ist dann die Möglichkeit gegeben, daß der Eingangsstrom der Schaltungsanordnung kapazitiv einen Wert zwischen Null und dem Strom durch die Kapazität annimmt. Wird die Verstärkung der Stromverstärker-Schaltung jedoch groß gewählt, so kann dieser Strom größer sein als der Strom durch die Kapazität. Durch die entsprechende Überlagerung fließt dann am Eingang der gesamten Schaltungsanordnung ein Strom mit 180 Grad Phasenverschiebung zu dem Strom durch die Kapazität. Man kann hierbei von einer negativen Wirkung der Kapazität sprechen, es handelt sich jedoch im Grunde genommen um einen induktiven Strom. Dieser induktive Strom kann betragsmäßig maximal die Größe des Stromes durch die Kapazität erreichen. Dabei hängt der maximale Betrag des Stromes von der Dimensionierung der Stromverstärkungsschaltung ab.

Der Stromverstärker für die Anordnung kann insbesondere als Differenzverstärker aufgebaut sein, dessen Ausgangssignale vorteilhafterweise mittels dreier Stromspiegel-Schaltungen zusammengeführt werden können, wobei dann ausgangsseitig der entsprechend dem Verstärkungsfaktor des Differenzverstärkers fließende Strom mit dem Strom durch die Kapazität zum Eingangsstrom der gesamten Schaltungsanordnung überlagert wird.

Nachfolgend wird anhand der Zeichnung die Erfindung näher erläutert. Es zeigen:

Fig. 1 eine Schaltungsanordnung zur Verstärkung der Wirkung der Kapazität,
Fig. 2 ein Ausführungsbeispiel der Schaltungsanordnung gemäß der Erfindung und
Fig. 3 die Schaltungsanordnung gemäß Fig. 2, mit anders ausgelegtem Stromverstärker, bei der auch eine negative Wirkung des Stromes durch die Kapazität erzeugt werden kann.

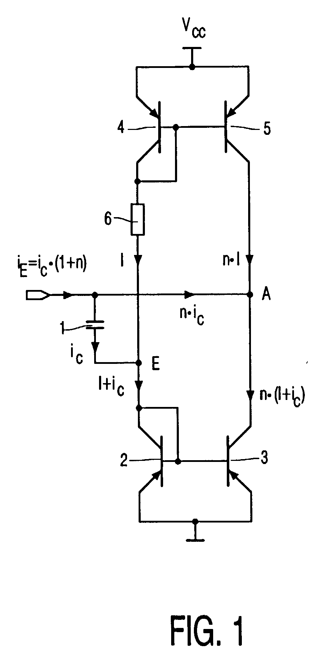

Eine in Fig. 1 dargestellte Schaltungsanordnung zur Verstärkung der Wirkung einer Kapazität 1 weist eine Stromspiegel-Schaltung mit einem Eingangstransistor 2 und einem Ausgangstransistor 3 auf.

Dieser Stromspiegel-Schaltung ist eingangsseitig ein konstanter Strom I zugeführt, zu dem sich der durch die Kapazität 1 fließende Strom $i_c$ addiert. Somit fließt am Eingang des Transistors 2 der Stromverstärker-Schaltung der Strom $I + i_c$.

Am Ausgang des Stromverstärkers 3 tritt dieser Strom verstärkt um das Verhältnis der Fläche des Transistors 2 zu der Fläche des Transistors 3 auf. Dieses Flächenverhältnis wird nachfolgend mit n bezeichnet. Der Strom im Ausgang der Stromverstärker-Schaltung, also im Kollektor des Transistors 3 beträgt somit $n \cdot (I + i_c)$.

Da dem Ausgang der Stromverstärker-Schaltung ein konstanter Strom $I \cdot n$ aufgeprägt ist, verbleibt für den mit dem Eingang der gesamten Schaltungsanordnung verbundenen Schaltungszweig noch ein Strom $n \cdot i_c$. Dieser Strom überlagert sich mit dem $i_c$ durch die Kapazität gleichsinnig, so daß am Eingang der gesamten Schaltungsanordnung ein Strom $i_c \cdot (1+n)$ fließt.

Im Ergebnis ist somit der Strom $i_c$ durch die Kapazität bezüglich seiner Wirkung verstärkt worden. Beträgt das Flächenverhältnis n=1, so fließt eingangsseitig ein Strom mit der doppelten Größe des Stromes durch die Kapazität und mit der gleichen Phasenlage dieses Stromes. Es ist im Ergebnis tatsächlich die Wirkung der Kapazität elektronisch verstärkt worden.

In der Schaltung gemäß Fig. 1 wird der der ersten Stromspiegel-Schaltung eingangsseitig fest aufgeprägte konstante Strom I über einen Widerstand R1 eingestellt, der mit dem Eingang einer zweiten Stromspiegel-Schaltung, welche einen Eingangstransistor 4 und einen Ausgangstransistor 5 aufweist, zugeführt. Diese zweite Stromspiegel-Schaltung ist gegen eine Versorgungsspannung $V_{cc}$ geschaltet. Die zweite Stromspiegel-Schaltung weist die gleiche Verstärkung auf wie die erste Stromspiegel-Schaltung, die Transistoren 4 und 5 weisen also das gleiche Flächenverhältnis n auf wie die

Transistoren 2 und 3 der ersten Stromspiegel-Schaltung. Damit erzeugt die zweite Stromspiegel-Schaltung ausgangsseitig einen Strom $n \cdot I$, der auf den Ausgang der ersten Stromspiegel-Schaltung gelangt.

Die Ströme I bzw. n•I, die durch die zweite Stromspiegel-Schaltung erzeugt werden, können auch durch Stromquellen oder durch andere Schaltungselemente erzeugt werden.

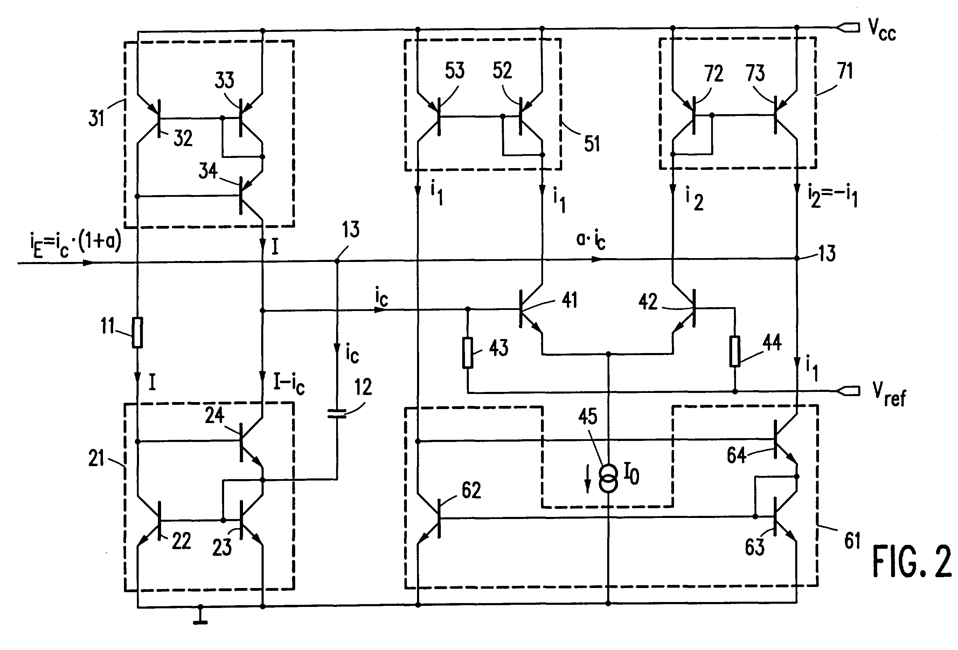

Fig. 2 zeigt eine Schaltungsanordnung zur elektronischen Verstärkung der Wirkung einer Kapazität gemäß der Erfindung.

Die Darstellung gemäß Fig.2 zeigt eine Wilson-Stromspiegel-Schaltung 21, welche einen ersten Transistor 22, einen zweiten Transistor 23 und einen dritten Transistor 24 aufweist. Der Kollektor des Transistors 22 bildet den Eingang der Wilson-Stromspiegel-Schaltung 21. Die Emitter der Transistoren 22 und 23 sind mit Bezugspotential verbunden. Die Basisanschlüsse der Transistoren 22 und 23 sind miteinander sowie mit einem Verbindungspunkt zwischen dem Transistor 23 und dem Transistor 24 verbunden, mit dem auch der Kollektor des Transistors 23 und der Emitter des Transistors 24 verbunden sind. Die Basis des Transistors 24 ist mit dem Eingang des Wilson-Stromspiegels verbunden. Der Kollektor des Transistors 24 bildet den Ausgang der Wilson-Stromspiegel-Schaltung.

Dem Eingang des Wilson-Stromspiegels 21 ist ein konstanter Strom I eingeprägt, der mittels eines Widerstandes 11 einstellbar ist. Der Widerstand 11 ist über einen Eingangstransistor 32 einer zweiten Wilson-Stromspiegel-Schaltung 31 mit Versorgungspotential $V_{cc}$ gekoppelt. Die zweite Wilson-Stromspiegel-Schaltung weist einen zweiten Transistor 33 sowie einen dritten Transistor 34 auf, die in bekannter Weise und entsprechend der Wilson-Stromspiegel-Schaltung 21 verschaltet sind, jedoch als Bezugspotential das Versorgungspotential $V_{cc}$ haben.

Geht man davon aus, daß sowohl der Wilson-Stromspiegel 21 wie auch der Wilson-Stromspiegel 31 eine Stromverstärkung von 1 aufweisen, so fließt am Ausgang des zweiten Wilson-Stromspiegels 31 ebenfalls der Strom I, der auf den Ausgang des ersten Wilson-Stromspiegels 21 geschaltet ist. Diesem Ausgangspunkt wird außerdem ein Strom $i_c$ entnommen. Dies erklärt sich daher, daß das Eingangssignal der gesamten Schaltungsanordnung über eine Kapazität 12 auf den Verbindungspunkt zwischen dem zweiten Transistor 23 und dem dritten Transistor 24 der Wilson-Stromspiegel-Schaltung 21 geführt ist. Fließt durch diese Kapazität 12 ein Strom $i_c$, so tritt dieser Strom ebenfalls am Ausgang der ersten Wilson-Stromspiegel-Schaltung 21 auf. Da der dem Eingang der Wilson-Stromspiegel-Schaltung 21 aufgeprägte konstante Strom I auch am Ausgang auftritt, wird dieser durch den Strom gleicher Größe I des zweiten Wilson-Stromspiegels 31 kompensiert. An dem Ausgangspunkt verbleibt damit der schon erwähnte Strom $i_c$.

Dieser Strom wird einer Differenzverstärker-Schaltung zugeführt, die aus einem ersten Transistor 41, einem zweiten Transistor 42, einem Widerstand 43, einem zweiten Widerstand 44 sowie einer Stromquelle 45 aufgebaut ist.

Der Strom $i_c$ gelangt auf die Basis des Transistors 41 sowie auf den Widerstand 43, der mit seinem anderen Anschluß auf ein Referenzpotential $V_{ref}$ geführt ist. In gleicher Weise ist der Widerstand 44 zwischen dieses Referenzpotential und die Basis des Transistors 42 geführt. Die Emitter der beiden Transistoren sind miteinander sowie mit der Stromquelle 45 verbunden, die einen Strom $I_0$ liefert. Die Kollektoren der Transistoren 41 und 42 stellen die beiden Ausgänge des Differenzverstärkers dar. Der Strom $i_c$ erzeugt am Widerstand 43 einen Spannungsabfall (der Basiseingang von Transistor 41 ist relativ hochohmig). Dieser Spannungsabfall teilt sich auf die beiden Emitterdioden von Transistor 41 und von Transistor 42 je zur Hälfte auf. Die Basis von Transistor 42 liegt dabei wechselstrommäßig auf der Referenzspannung $V_{ref}$. Da die Diode von Transistor 42 entgegengesetzt geschaltet ist, bewirkt sie einen Strom mit 180° Phasenverschiebung.

Setzt man die Steilheit g der Transistoren 41 und 42 an mit

$$g = \frac{I_0/2}{V_T}$$

worin $V_T$ die Temperaturspannung der Transistoren ist, so beträgt der Ausgangsstrom $i_1$ des Transistors 41

$$i_1 = \frac{i_c \cdot R_{43}}{2} \cdot \frac{I_0/2}{V_T}$$

Der Ausgangsstrom $i_2$ des Transistors 42 des Differenzverstärkers hat den gleichen Wert, jedoch mit umgekehrtem Vorzeichen, d.h. es gilt $i_2 = -i_1$.

Der Strom $i_1$ ist der Eingangsstrom einer Stromspiegelschaltung 51, welche in konventioneller Weise mit zwei Transistoren 52 und 53 aufgebaut ist, welche emitterseitig auf die Versorgungsspannung $V_{cc}$ arbeiten. Am Ausgang dieser Stromspiegelschaltung 51 fließt dann ebenfalls der Strom $i_1$, der einem Eingang einer Wilson-Stromspiegel-Schaltung 61 zugeführt ist. Die Stromspiegel-Schaltung 61 ist entsprechend der Stromspiegel-Schaltung 21 mit einem ersten Transistor 62, einem zweiten Transistor 63 sowie einem vierten Transistor 64 aufgebaut. Am Ausgang dieser Wilson-Stromspiegel-Schaltung 61 fließt wiederum der Strom $i_1$.

Der Strom $i_2$, der im Kollektor des Verstärkers 42 fließt, gelangt an einen Eingang einer weiteren Stromspiegel-Schaltung 71, die in entsprechender Weise zu der Stromspiegel-Schaltung 51 mit einem Eingangstransistor 72 und einem Ausgangstransistor 73 aufgebaut ist. Ausgangsseitig liefert diese Stromspiegel-Schaltung 71 den Strom $i_2 = -i_1$.

In der Darstellung gemäß Fig. 2 ist ein Knotenpunkt 13 eingezeichnet, wobei im folgenden nur die Signalströme, also Wechselströme betrachtet werden, nicht hingegen die Gleichströme die fließen; für diesen Knotenpunkt gilt folgende Stromsumme:

$$\text{Eingangsstrom } i_E = i_c + i_1 - i_2$$
$$\text{mit } i_2 = -i_1 \text{ gilt } i_E = i_c + 2 \cdot i_1.$$

Da

$$i_1 = \frac{i_c \cdot R_{44}}{2} \cdot \frac{I_0/2}{V_T}$$

ist, gilt

$$i_E = i_c \cdot (1 + R_{44} \cdot \frac{I_0/2}{V_T})$$

Hierin kann der Ausdruck

$$I_0 \cdot \frac{R_{44}/2}{V_T}$$

als Faktor a angesehen werden, der den Stromverstärkungsfaktor des Differenzverstärkers darstellt.

Somit beträgt dann der Eingangsstrom der gesamten Schaltungsanordnung $i_E = i_c \cdot (1+a)$.

Bei der Schaltungsanordnung gemäß Fig. 2 überlagern sich die Ströme $i_c$ und $a \cdot i_c$ in dem Knoten 13 mit gleichem Vorzeichen und gleicher Phasenlage, so daß der Eingangsstrom der Gesamtschaltungsanordnung $i_E = i_c \cdot (1+a)$ größer ist als der Strom $i_c$. Dieser Strom hat gleiche Phasenlage wie der Strom $i_c$ durch die Kapazität 12, weist jedoch größere Werte auf. Der Faktor a kann dadurch variabel gemacht werden, daß der Strom $I_0$ der Stromquelle 45 seinerseits variabel gestaltet wird. Wird der Strom $I_0$ verändert, ändert sich entsprechend der Faktor a. Damit kann über die Änderung des Stromes $I_0$ des Differenzverstärkers eine Veränderung der elektronischen Verstärkung der Wirkung der Kapazität 12 bzw. des durch diese fließenden Stromes $i_c$ erzeugt werden. Der Faktor a kann also variabel angenommen werden und erlaubt somit die Simulation einer Kapazität variabler Größe. Diese Eigenschaft macht die Schaltung beispielsweise für spannungsgesteuerte Oszillatoren geeignet.

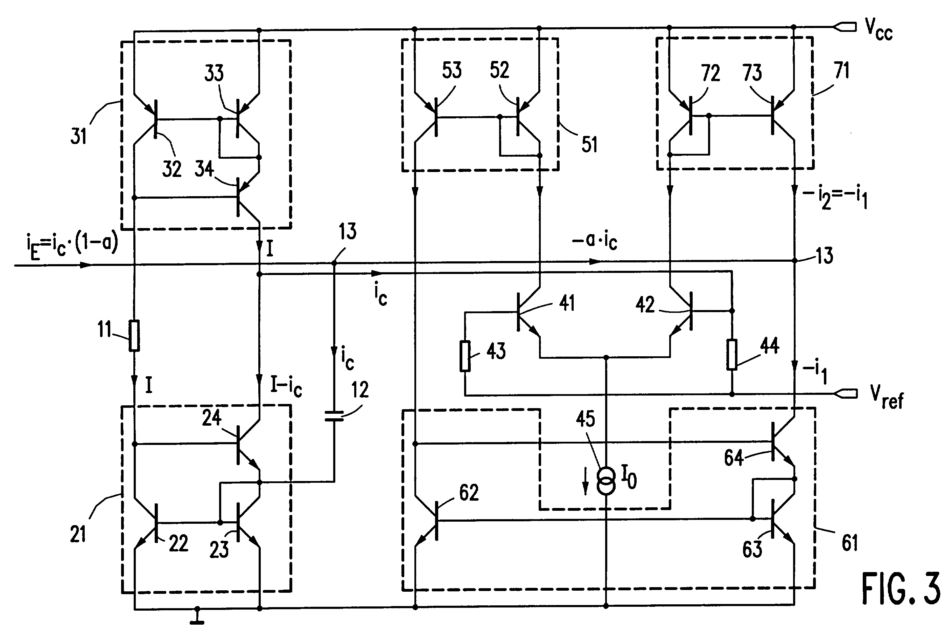

Fig. 3 zeigt eine Schaltungsanordnung gemäß Fig. 2, jedoch mit dem Unterschied, daß der Strom $i_c$, wie er aus dem Verbindungspunkt der beiden Ausgänge der Stromspiegel 31 bzw. 21 fließt, nicht dem Verbindungspunkt zwischen dem Widerstand 43 und dem Differenzverstärker 41, sondern dem Verbindungspunkt zwischen dem Widerstand 44 und dem Transistor 42 des Differenzverstärkers zugeführt wird. Damit wird erreicht, daß der Differenzverstärker Ausgangsströme mit umgekehrtem Vorzeichen liefert.

Dies zeigt sich in der Darstellung gemäß Fig.

3 durch die negativen Vorzeichen der Ausgangsströme $i_2$ bzw. $i_1$ der Stromspiegelschaltungen 71 bzw. 61.

Für den Gesamtstrom bzw. den Eingangsstrom der Gesamtanordnung $i_E$ bedeutet dies: $i_E = i_c \cdot (1-a)$. Der Strom $i_c$ durch die Kapazität 12 und der Strom, der vom Verbindungspunkt der Ausgänge der Stromspiegel-Schaltung 71 und 61 geliefert wird, überlagern sich hier in der Weise, daß der Ausgangsstrom der beiden Stromspiegel-Schaltungen umgekehrtes Vorzeichen hat verglichen mit dem Strom $i_c$ durch die Kapazität 12. Damit ist der Strom $i_E$ der Gesamtschaltung kleiner als der Strom $i_c$ durch die Kapazität. Es kann hier ein Strom zwischen 0 und maximal dem Strom $i_c$ eingestellt werden. Es besteht aber darüber hinaus die Möglichkeit, den Strom $-a \cdot i_c$, den die Ausgänge der Stromspiegel-Schaltungen 71 bzw. 61 liefern, betragsmäßig größer zu machen als den Strom $i_c$ durch die Kapazität 12. Dies hat zur Folge, daß auf diese Weise eine negative Kapazität erzeugt werden kann. Der Strom $i_E$ in die Gesamtschaltung hat somit eine zu dem kapazitiven Strom durch die Kapazität 12 um 180 Grad verschobene Phasenlage. Diese negative Kapazität kann auch als Induktivität aufgefaßt werden. Durch die Wahl der Überlagerung der Ausgangsströme der beiden Stromspiegel 61 bzw. 71 und des Stroms durch die Kapazität 12 kann also auch eine variable Induktivität bzw. eine negative Kapazität erzeugt werden.

Die Ausführungsbeispiele gemäß Fig. 2 und 3 zeigen, daß je nach Wahl des Stromverstärkers, der in diesen Ausführungsbeispielen durch den Differenzverstärker und die Stromspiegel 51, 61 und 71 gebildet wird, der Strom durch die Kapazität und der Ausgangsstrom dieses Stromverstärkers entweder so überlagert werden können, daß die Wirkung der Kapazität vergrößert wird, oder so überlagert werden können, daß die Wirkung der Kapazität verkleinert werden kann, bis hin zur Wirkung einer negativen Kapazität, die wie eine Induktivität wirkt.

**Patentansprüche**

1. Schaltungsanordnung zur Verstarkung der Wirkung einer Kapazität (1),
   dadurch gekennzeichnet, daß eine Wilson-Stromspiegel-Schaltung (21) vorgesehen ist, welche einen ersten Transistor (22) aufweist, dessen Kollektor den Eingang der Stromspiegel-Schaltung bildet, dessen Emitter auf Bezugspotential geführt ist und dessen Basis mit der Basis eines zweiten in der Stromspiegel-Schaltung vorgesehenen zweiten Transistors (23) verbunden ist, dessen Emitter mit Bezugspotential und dessen Kollektor mit dessen Basis und mit dem Emitter eines dritten in der Stromspiegel-Schaltung (21) vorgesehenen Transistors (24) verbunden ist, dessen Basis mit dem Eingang der Wilson-Stromspiegel-Schaltung (21) verbunden ist und dessen Kollektor den Ausgang der Stromspiegel-Schaltung (21) bildet, daß der Eingang der Schaltungsanordnung mit dem Ausgang einer, Stromverstärker-Schaltung (41, 42, 43, 44, 51, 61, 72) und über die Kapazität (12) mit dem Verbindungspunkt zwischen dem zweiten (23) und dem dritten (24) Transistor der Wilson-Stromspiegel-Schaltung (21) verbunden ist, daß der Ausgang der Wilson-Stromspiegel-Schaltung (21) mit dem Eingang der Stromverstärker-Schaltung (41, 42, 43, 44, 51, 61, 72) verbunden ist und daß auf den Eingang und auf den Ausgang der Wilson-Stromspiegel-Schaltung (21) zusätzlich konstante Ströme (I) jeweils gleicher Größe geführt sind.

**2.** Schaltungsanordnung nach Anspruch 1,
_dadurch gekennzeichnet_, daß die Steilheit der Stromverstärkungs-Kennlinie der Stromverstärker-Schaltung (41, 42, 43, 44, 51, 61, 72) einstellbar ist.

**3.** Schaltungsanordnung nach Anspruch 2,
_dadurch gekennzeichnet_, daß die Stromverstärker-Schaltung (41, 42, 43, 44, 51, 61, 72) eine solche Stromverstärkung aufweist, so daß der in die Schaltungsanordnung hineinfließende Strom größer als der durch die Kapazität (12) fließende Strom ist.

**4.** Schaltungsanordnung nach Anspruch 2,
_dadurch gekennzeichnet_, daß die Stromverstärker-Schaltung (41, 42, 43, 44, 51, 61, 72) eine solche Stromverstärkung aufweist, so daß der in die Schaltungsanordnung hineinfließende Strom kleiner als der durch die Kapazität (12) fließende Strom ist und gleiche oder um 180 Grad verschobene Phasenlage aufweist.

**5.** Schaltungsanordnung nach einem der Ansprüche 2 bis 4,
_dadurch gekennzeichnet_, daß die Stromverstärker-Schaltung (41, 42, 43, 44, 51, 61, 72) als Differenzverstärker aufgebaut ist.

**6.** Schaltungsanordnung nach Anspruch 5,
_dadurch gekennzeichnet_, daß die Ausgangssignale des Differenzverstärkers mittels dreier Stromspiegel-Schaltungen (51, 61, 71) zusammengeführt werden.

**7.** Verwendung der Schaltungsanordnung nach einem der Ansprüche 1 bis 6 in einem spannungsgesteuerten Oszillator.

## Claims

**1.** A circuit arrangement for amplifying the effect of a capacitance (1),
_characterized in that_ there is provided a Wilson current minor circuit (21), which comprises a first transistor (22) whose collector forms the input of the current mirror circuit, whose emitter is coupled to reference potential, and whose base is connected to the base of a second transistor (23) of the current mirror circuit, which second transistor has its emitter connected to the reference potential and its collector to its base and to the emitter of a third transistor (24) of the current mirror circuit (21), the base of said third transistor being connected to the input of the Wilson current mirror circuit (21) and the collector of this transistor forming the output of the current mirror circuit (21), in that the input of the circuit arrangement is connected to the output of a current amplifier circuit (41, 42, 43, 44, 51, 61, 72) and, via the capacitance (12), to the node between the second (23) and the third (24) transistor of the Wilson current mirror circuit (21), in that the output of the Wilson current mirror circuit (21) is connected to the input of the current amplifier circuit (41, 42, 43, 44, 51, 61, 72), and in that, in addition, constant currents (I) of equal magnitude are applied to the input and to the output of the Wilson current mirror circuit (21).

**2.** A circuit arrangement as claimed in claim 2,
_characterized in that_ the slope of the current-gain characteristic of the current amplifier circuit (41, 42, 43, 44, 51, 61, 72) is adjustable.

**3.** A circuit arrangement as claimed in claim 2,
_characterized in that_ the current amplifier circuit (41, 42, 43, 44, 51, 61, 72) has such a current gain that the current which flows into the circuit arrangement is larger than the current flowing through the capacitance (12).

**4.** A circuit arrangement as claimed in claim 2,
_characterized in that_ the current amplifier circuit (41, 42, 43, 44, 51, 61, 72) has such a current gain that the current which flows into the circuit arrangement is smaller than the current flowing through the capacitance (12) and is in phase or 180 degrees phase-shifted.

**5.** A circuit arrangement as claimed in any one of the claims 2 to 4,
_characterized in that_ the current amplifier circuit (41, 42, 43, 44, 51, 61, 72) is constructed as a differential amplifier.

**6.** A circuit arrangement as claimed in claim 5,
_characterized in that_ the output signals of the differential amplifier are combined by means of three current mirror circuits (51, 61, 71).

**7.** The use of the circuit arrangement as claimed in any one of the claims 1 to 6 in a voltage-controlled oscillator.

**Revendications**

1. Circuit d'amplification de l'action d'une capacité (1) caractérisé en ce qu'un circuit de miroir de courant de Wilson (21) est prévu et présente un premier transistor (22) dont le collecteur forme l'entrée du circuit de miroir de courant, dont l'émetteur est amené au potentiel de référence et dont la base est reliée à la base d'un deuxième transistor (23) prévu dans le circuit de miroir de courant dont l'émetteur est relié au potentiel de référence et dont le collecteur est relié à sa base et à l'émetteur d'un troisième transistor 24 prévu dans le circuit de miroir de courant (21) dont la base est reliée à l'entrée du circuit de miroir de courant de Wilson (21) dont le collecteur forme la sortie du miroir de courant (21), que l'entrée du circuit est reliée à la sortie d'un circuit amplificateur de courant (41, 42, 43, 44, 51, 61, 72) et par l'intermédiaire de la capacité (12) au point de jonction entre les deuxième (23) et troisième (24) transistors du circuit de miroir de courant de Wilson (21), que la sortie du circuit de miroir de courant de Wilson (21) est reliée à l'entrée du circuit amplificateur de courant (41, 42, 43, 44, 51, 61, 72) et que des courants constants (1) de même grandeur respective sont amenés par ailleurs à l'entrée et à la sortie du circuit de miroir de courant de Wilson (21).

2. Circuit selon la revendication 1, caractérisé en ce que la pente de la caractéristique d'amplification du courant du circuit amplificateur de courant (41, 42, 43, 44, 51, 61, 72) est réglab le.

3. Circuit selon la revendication 2, caractérisé en ce que le circuit amplificateur de courant (41, 42, 43, 44, 51, 61, 72) présente une amplification de courant telle que le courant circulant dans le circuit est supérieur au courant circulant par la capacité (12).

4. Circuit selon la revendication 2, caractérisé en ce que le circuit amplificateur de courant (41, 42, 43, 44, 51, 61, 72) présente une amplification de courant telle que le courant circulant dans le circuit est inférieur au courant circulant par la capacité (12) et présente une phase identique ou déphasée de 180°.

5. Circuit selon l'une des revendications 2 à 4, caractérisé en ce que le circuit amplificateur de courant (41, 42, 43, 44, 51, 61, 72) est conçu comme un amplificateur différentiel.

6. Circuit selon la revendication 5, caractérisé en ce que les signaux de sortie de l'amplificateur différentiel sont combinés à l'aide de trois circuits de miroir de courant (51, 61, 71).

7. Mise en oeuvre du circuit selon l'une des revendications 1 à 6 dans un oscillateur commandé par tension.

FIG. 1

FIG. 2

EP 0 692 870 B1

FIG. 3